## Europäisches Patentamt
## European Patent Office
## Office européen des brevets

(19)

(11) Veröffentlichungsnummer: **0 321 727 B1**

# EUROPÄISCHE PATENTSCHRIFT

(12)

(45) Veröffentlichungstag der Patentschrift: **18.03.92**

(51) Int. Cl.⁵: **G07F 7/08**, G11C 16/06

(21) Anmeldenummer: **88119598.6**

(22) Anmeldetag: **24.11.88**

(54) **Verfahren und Schaltung zum manipuliergeschützten Entwerten von EE-PROM-Speichern.**

(30) Priorität: **17.12.87 DE 3742894**

(43) Veröffentlichungstag der Anmeldung:
**28.06.89 Patentblatt 89/26**

(45) Bekanntmachung des Hinweises auf die
Patenterteilung:
**18.03.92 Patentblatt 92/12**

(84) Benannte Vertragsstaaten:
**AT BE CH DE ES FR GB IT LI LU NL SE**

(56) Entgegenhaltungen:
**EP-A- 0 123 177**
**EP-A- 0 129 054**
**FR-A- 2 463 457**

**PATENT ABSTRACTS OF JAPAN, Band 5, Nr.
134 (P-77)[806], 26. August 1981, Seite 119 P
77; & JP-A-56 71 885 (NIPPON DENKI K.K.)
15-06-1981**

(73) Patentinhaber: **SIEMENS AKTIENGESELL-
SCHAFT**
**Wittelsbacherplatz 2**
**W-8000 München 2(DE)**

(72) Erfinder: **Schrenk, Hartmut, Dr.**
**Fasanenweg 22**
**W-8013 Haar(DE)**

EP 0 321 727 B1

**Beschreibung**

Die Erfindung betrifft ein Verfahren zum Entwerten der monolithisch integrierbaren elektronischen Schaltung einer Debit-Karte nach dem Oberbegriff des Patentanspruchs 1 und eine Schaltung zur Durchführung des Verfahrens nach dem Oberbegriff des Patentanspruches 3.

Zum bargeldlosen Bezahlen von Waren oder zum Abrechnen von Dienstleistungen und ähnlichem sind datengesteuerte Zahlungssysteme in Form von Datenaustauschsystemen bekannt, die beispielsweise in dem Artikel "Einsatzmöglichkeiten der Chip-Karte" von Danneck im Handbuch der modernen Datenvermittlung, Heft 136, Juli 1987 beschrieben sind. Die dabei verwendeten Chip-Karten enthalten als ein wesentliches Element einen nichtflüchtigen elektronischen Datenspeicher, auf den über elektrische Kontakte an der Kartenoberfläche zugegriffen werden kann. Über eine Datenein-/Datenausgabeeinrichtung wird von einer Recheneinheit bei jedem Gebrauch auf den Speicherinhalt zugegriffen, der dabei gegebenenfalls geändert wird.

Speziell bei der Verwendung in Debit-Karten, das sind vorausbezahlte Datenträgeranordnungen, die eine anonyme Bezahlung von Waren oder gebührenpflichtigen Diensten ermöglichen, muß sichergestellt sein, daß der "Wert" der Karten durch Manipulation nur verringert, nicht aber erhöht werden kann.

Bisher wird als Schutz gegen das Verändern oder Löschen des in solchen Karten enthaltenen Speichers, wie auch in dem oben erwähnten Artikel "Einsatzmöglichkeiten der Chip-Karte" beschrieben, ein Speicher in elektrisch nicht löschbarer E-PROM-Technik verwendet. Auf diese Art geschützte Schaltkreise, wie z.B. der TS1001 der Firma Thompson Semiconductors, benötigen für jede vorbezahlbare und abbuchbare Einheit eine eigene Speicherzelle, so daß die Zahl der maximal verfügbaren Einheiten beim Einsatz in genormten Chip-Karten durch die zur Verfügung stehende Chip-Fläche stark begrenzt wird.

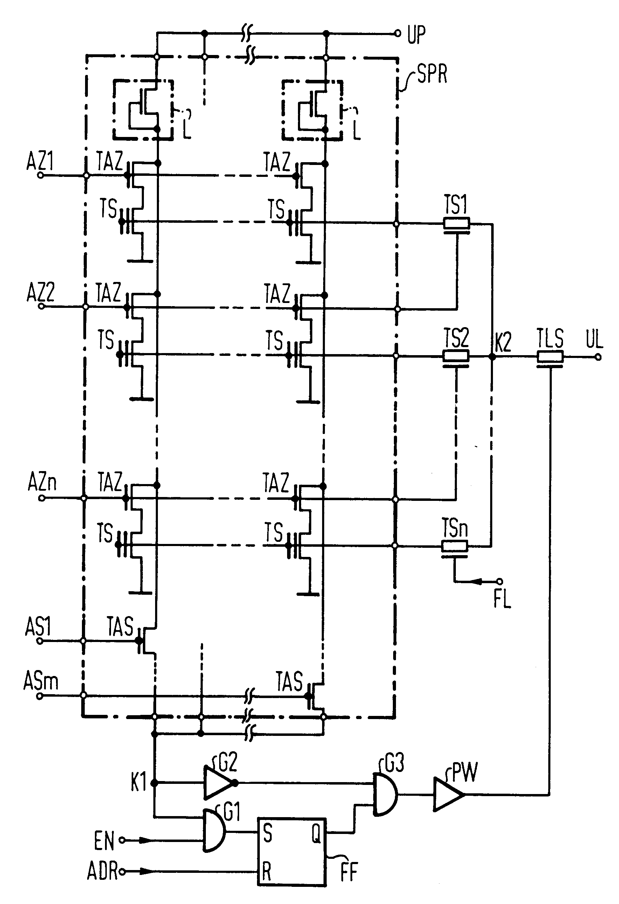

Aus dem Artikel "16-k EE-PROM relies on tunneling for byte-erasable program storage" von Johnson/Kuhn/Renninger/Perelegos, Electronics, 28. Februar 1980, ist ein elektrisch löschbarer Speicher bekannt, wobei das Speicherzellenfeld aus in Matrix-Form angeordneten Speicherzellen mit Speichertransistoren vom floating-Gate-Typ, deren Gateanschlüsse (Steuergate der Speicherzelle) zeilenweise zusammen an eine Steuerleitung angeschlossen sind und mit Auswahltransistoren, deren Gateanschlüsse (Auswahlgate der Speicherzelle) zeilenweise zusammen an eine Auswahlleitung angeschlossen sind, wobei die einzelnen Auswahlleitungen von den entsprechenden Ausgängen eines Zeilendecoders ansteuerbar sind. Dieser Speicher ist vollständig oder zeilenweise löschbar, wobei die zu löschende Zeile über die Auswahlleitung ausgewählt sein muß. In der EP-OS 0 123 177, insbesondere in Figur 2, wird eine Ausführungsform einer solchen Speichermatrix beschrieben, wobei die Auswahltransistoren der einzelnen, zu einer Zeile gehörenden Speicherzellen jeweils mit ihrem Drain-Anschluß an eine Spaltenleitung und mit ihrem Source-Anschluß an den Drain-Anschluß des zugehörigen Speichertransistors vom Floating-Gate-Typ angeschlossen sind, wobei der Source-Anschluß des Speichertransistors jeweils an ein Bezugspotential geschaltet ist, wobei die einzelnen Spaltenleitungen jeweils über ein Lastelement an das Programmierpotential angeschlossen sind und jeweils über einen als Schalter eingesetzten Spaltenauswahltransistor an einen den Dateninhalt der ausgewählten Speicherzelle bereitstellenden Schaltungsknoten schaltbar ist. Die Gateanschlüsse der einzelnen Spaltenauswahltransistoren werden hierbei von den entsprechenden Ausgängen eines Spaltendecoders angesteuert. Die Steuerleitungen der einzelnen Speicherzellen-Zeilen sind über je ein Lastelement an das Programmierpotential, insbesondere das Löschpotential angeschlossen und können sowohl über einen von einem Schreibsignal steuerbaren Transistor, als auch über einen von einer aufwendigen Logikschaltung steuerbaren Transistor in Abhängigkeit von dem Steuerleitungspotential an das Bezugspotential geschaltet werden, um ein Löschen zu verhindern.

Ein Löschvorgang ist in Schaltungen nach der EP-OS 0 123 177 nur zeilenweise möglich, nachdem das Einschreiben eines Kontrollbit in einen nicht löschbaren Kontrollspeicher erfolgt ist. Hierbei wird die Zahl der Zeilen-Löschvorgänge durch die Zahl der zur Verfügung stehenden nicht löschbaren Kontrollspeicherzellen begrenzt, so daß das Verhältnis zwischen der Zahl der vorhandenen Speicherzellen und der Zahl der eindeutig erfaßbaren Ereignisse nur geringfügig besser ist als bei E-PROM-Speichern. Durch die in der EP-OS 0 123 177 beschriebenen Schaltung ist ein kontrolliertes Löschen des nichtflüchtigen Speichers durch einen relativ großen Schaltungsaufwand und unter Benötigung zusätzlicher Signale möglich. Dadurch wird die infolge der Mehrfachbenutzung der Speicherzellen gegenüber E-PROM-Schaltkreisen gleicher Einheitenzahl eingesparte Chip-Fläche teilweise durch eine aufwendige Logikschaltung und den Kontrollspeicher belegt.

Aufgabe der Erfindung ist die Bereitstellung eines Verfahrens, um mit einem EE-PROM geringer Speicherzellenzahl und einer einfachen Kontrollschaltung eine eindeutige, nicht manipulierbare Registrierung einer großen Zahl von Ereignissen zu ermöglichen sowie die Bereitstellung einer elektronischen Schaltung zur Durchführung des Verfahrens.

2

Diese Aufgabe wird bei einem gattungsgemäßen Verfahren nach dem kennzeichnenden Teil des Patentanspruches 1 gelöst.

Eine Schaltung nach dem Patentanspruch 3 ermöglicht die Durchführung eines solchen Verfahrens.

Besonders günstige Ausgestaltungsformen sind Gegenstand von Unteransprüchen.

Ein eindeutiges, manipuliersicheres Entwerten der monolithisch integrierbaren elektronischen Schaltung einer Debit-Karte, die mindestens aus einer Adreß- und Steuerlogikschaltung und einem nichtflüchtigen Speicher besteht, wobei zumindest ein Teil dieses Speichers elektrisch löschbar ist und alle Speicherplätze des zum Speichern des jeweiligen Entwertungszustandes vorgesehenen Bereiches des nichtflüchtigen Speichers auslesbar und bitweise beschreibbar sind, wird dadurch ermöglicht, daß der besagte, zum Speichern des Entwertungszustandes der Debit-Karte vorgesehene Bereich des Speichers in Teilbereiche (Bytes) jeweils unterschiedlicher Wertigkeit aufgeteilt ist und als mehrstufiger Zähler benutzt wird, daß aufgrund schaltungstechnischer Maßnahmen ein Löschen der Speicherzellen nur für alle Speicherzellen eines Teilbereiches bestimmter Wertigkeit gleichzeitig möglich ist und jeder Teilbereich nur gelöscht werden kann, nachdem das Einschreiben eines Übertragbit in eine zuvor unbeschriebene Speicherzelle des Teilbereiches der nächsthöheren Wertigkeit erfolgt ist und dieses Einschreiben von einer Logikschaltung überwacht worden ist und daß ein Löschen des Teilbereiches der höchsten Wertigkeit nur unter besonderen Bedingungen möglich ist, insbesondere daß das Löschen des Teilbereiches der höchsten Wertigkeit vor dem Aktivieren der Schaltungsanordnung durch das Zerstören einer Schmelzsicherung für die Zukunft unterbunden wird.

Hierbei bilden jeweils eine oder mehrere Speicherzellen-Zeilen einen Teilbereich, dem jeweils eine eigene Wertigkeit zugeordnet ist. Die Speicherzellen des Teilbereiches niedrigster Wertigkeit werden zum Entwerten nacheinander beschrieben. Sind alle Speicherzellen dieses Teilbereiches beschrieben, wird eine zuvor unbeschriebene Speicherzelle im Bereich der nächsthöheren Wertigkeit beschrieben, dieser Vorgang überprüft und dann alle Speicherzellen des Bereiches der niedrigeren Wertigkeit gelöscht. Daraufhin werden wieder alle Speicherzellen des Bereiches der niedrigsten Wertigkeit nacheinander beschrieben und das Verfahren wird in allen Teilbereichen fortgesetzt, bis alle Speicherzellen beschrieben sind.

Nachstehend wird ein möglicher Zählablauf am Beispiel eines Speichers mit drei Teilbereichen verschiedener Wertigkeit und drei Bit pro Teilbereich bestimmter Wertigkeit teilweise dargestellt. Hierbei entspricht eine 0 dem HIGH-Zustand einer EE-PROM-Speicherzelle und eine 1 dem LOW-Zustand. Die Spalten stellen die verschiedenen Teilbereiche dar, wobei deren Wertigkeit von links nach rechts Zunimmt.

```
000 000 000
001 000 000
011 000 000
111 000 000
000 001 000
001 001 000
011 001 000
111 001 000
000 011 000

000 111 000
000 000 001

011 111 111
111 111 111
```

Die Figur zeigt von einem Ausführungsbeispiel der Erfindung den Speicherbereich SPR, der zum Speichern des jeweiligen Entwertungszustandes der Debit-Karte vorgesehen ist sowie die Logikschaltung, die dafür sorgt, daß dieser Speicher bei Ansteuerung als Zähler nicht rücksetzbar ist.

Die Durchführung des beanspruchten Verfahrens wird ermöglicht durch eine monolithisch integrierbare Schaltung unter Verwendung eines elektrisch löschbaren Speichers mit matrixförmig angeordneten Zweitransistor-Speicherzellen mit Auswahltransistor TAZ und Speichertransistor TS, die über Zeilenauswahlleitungen AZ1, ..., AZn und Spaltenauswahlleitungen AS1, ..., ASm einzeln auswählbar sind, wobei die Speicherzellen zeilenweise mit ihren Steuergateanschlüssen an einer gemeinsamen Steuerleitung angeschlossen sind, wobei die Drainanschlüsse der Speicherzellen-Auswahltransistoren TAZ spaltenweise an Spaltenleitungen angeschlossen sind, wobei diese Spaltenleitungen jeweils über ein Lastelement L an das Programmierpotential UP angeschlossen sind und über Schalttransistoren TAS, die über die an ihre Gateanschlüsse angeschlossenen Spaltenauswahlleitungen AS1, ..., ASm angesteuert werden können, an

EP 0 321 727 B1

einen gemeinsamen ersten Schaltungsknoten K1 geschaltet sind, wobei erfindungsgemäß die Steuerleitungen der einzelnen Speicherzellen-Zeilen über je einen Schalttransistor TS1, TS2, ..., TSn an einen gemeinsamen zweiten Schaltungsknoten K2 schaltbar sind, wobei der Gateanschluß eines jeden dieser Schalttransistoren TS1, TS2, ..., TSn-1 an die Zeilenauswahlleitung des Bereiches nächsthöherer Wertigkeit angeschlossen ist und der Gateanschluß des Schalttransistors des Bereiches der höchsten Wertigkeit über eine speziell gesicherte Leitung FL, die insbesondere mit einer Schmelzsicherung, beispielsweise einer fusible link, ausgestattet ist und insbesondere nur unter Verwendung eines Sicherungs-Codes aktiviert werden kann, ansteuerbar ist, wobei der zweite Schaltungsknoten K2 über einen Löschschalttransistor TLS an ein Löschpotential UL schaltbar ist, wobei der erste Schaltungsknoten K1 an einen Eingang eines ersten UND-Gatters G1 und an den Eingang einer Invertierschaltung G2 geschaltet ist, wobei der andere Eingang des ersten UND-Gatters G1 von einem üblichen Bewertungssignal EN beaufschlagbar ist, wobei der Ausgang des ersten UND-Gatters G1 an den Setz-Eingang S eines Flip-Flop FF angeschlossen ist, wobei der Rücksetzeingang R des Flip-Flop FF bei jedem Adreßwechsel von der Adreßlogikschaltung mit einem Rücksetzsignal beaufschlagt wird, wobei der Ausgang dieses Flip-Flop FF mit dem Eingang eines zweiten UND-Gatters G3 verbunden ist und der andere Eingang dieses zweiten UND-Gatters G3 an den Ausgang der Invertierschaltung G2 angeschlossen ist und wobei das Ausgangssignal des zweiten UND-Gatters G3 zur Beaufschlagung des Steuereinganges des Löschschalttransistors TLS vorgesehen ist. Der Ausgang des zweiten UND-Gatters G3 ist hierbei insbesondere über eine Pegelwandlerschaltung PW an den Gate-Anschluß des Löschsschalttransistors TLS koppelbar.

Wird ein Ausführungsbeispiel nach der Figur derart ausgeführt, daß acht Speicherzellen jeweils eine Zeile bilden und jede Zeile einen Teilbereich bestimmter Wertigkeit darstellt und daß fünf verschiedenwertige Zeilen übereinander angeordnet sind, so können mit diesen 40 Speicherzellen bis zu $8^5$ = 32768 Einheiten registriert werden.

Die verwendeten Flotox-Speicherzellen werden beschrieben, wenn ihr Steuergate auf niedrigem Potential liegt und der Drainanschluß infolge des durchgesteuerten Auswahltransistors auf Programmierpotential, beispielsweise 20 Volt, liegt. Ein Löschen der Speicherzellen erfolgt dadurch, daß das Steuergate auf Löschpotential, üblicherweise ca. 20 Volt, geschaltet wird.

Im Ausführungsbeispiel werden also immer alle acht Bit eines Teilbereiches bestimmter Wertigkeit gleichzeitig gelöscht.

Die in der Figur dargestellte Logikschaltung löst die sicherheitsbedingte logische Zuordnung von Schreiben in einen höherwertigen Zeilenbereich und Löschen der niederwertigeren Adressen durch die spezielle Konfiguration der EE-PROM-Zeilensteuerung. Das Zeilenauswahlsignal der jeweils ausgewählten Zeile ermöglicht das Schreiben der Speicherzellen der ausgewählten Zeile, der Schalttransistor dieser Zeile unterbindet jedoch das Löschen dieser Speicherzellen.

Ist z.B. die Auswahlleitung AZ1 der ersten Zeile auf High-Potential, so ist der Schalttransistor TS1 gesperrt. Ist jedoch die Auswahlleitung AZ2 der zweiten Zeile aktiviert, so ist der Schalttransistor TS2, der diese mit dem zweiten Knoten K2 verbindet gesperrt, der Schalttransistor TS1 der ersten Zeile jedoch durchgesteuert. Dadurch wird das am zweiten Schaltungsknoten K2 anstehende Potential an die Steuerleitung der ersten Zeile durchgeschaltet. Wenn nun der Löschschalttransistor TLS, der von der Logikschaltung angesteuert wird, durchgeschaltet ist, so wird die erste Zeile gelöscht.

Der Ablauf der Logikschaltung dieses Ausführungsbeispieles wird nachstehend beschrieben:
Nach Einstellen einer Adresse, beispielsweise in der zweiten Zeile (AZ2 = HIGH) läßt sich im Falle einer noch gelöschten Speicherzelle am ersten Knoten K1, der der Datenleitung entspricht, eine "1" auslesen. Während einer Bewertungsphase, in der das Bewertungssignal EN, das zur Beaufschlagung eines Einganges des ersten UND-Gatters dient, auf High-Potential liegt, wird also das Flip-Flop FF gesetzt. Solange die angewählte Speicherzelle jedoch gelöscht ist, ist das zweite UND-Gatter G3 noch über die Invertierschaltung G2 gesperrt, so daß auch der Löschschalttransistor TLS sperrt und ein Löschen der ersten Zeile verhindert. Das zweite UND-Gatter G3 wird erst freigegeben, nachdem die eingestellte Speicherzelle auf "0" geschrieben worden ist. Ein Adreßwechsel zwischen Schreib- und Löschvorgang würde das Flip-Flop FF über das Adreßwechselsignal ADR am Rücksetzeingang R zurücksetzen, so daß der Löschvorgang wieder blockiert wäre. Wird jedoch eine bereits geschriebene Zelle adressiert, so bleibt das Flip-Flop FF gesperrt.

Diese Logikschaltung gewährleistet also einen manipuliersicheren Ablauf, indem für jedes freie Bit der höherwertigen EE-PROM-Zeile genau einmal eine niederwertige Zeile gelöscht werden kann, wobei dieses Löschen nicht zwingend erforderlich ist. Wird eine höherwertige Zeile aufgrund des Einschreibens eines Übertragbit in eine noch höherwertigere Zeile gelöscht, so ist das Löschen der niederwertigeren Zeile wieder für jedes Bit dieser jetzt gelöschten Zeile möglich. Der zur Registrierung eines Übertragbit erforderliche Ablauf ist durch diese Logikschaltung sichergestellt.

4

Die höchstwertige Speicherzeile kann nur bei durchgesteuertem Schalttransistor TSn dieser Zeile erfolgen. Dieser Schalttransistor TSn wird jedoch über eine mit einer Schmelzsicherung ausgestatteten Leitung FL angesteuert. Solche Sicherungen sind unter dem Namen fusible link bekannt und unter anderem in der EP-OS 0 123 177 erwähnt. Nach dem Aktivieren des Schaltkreises, also dem Durchbrennen dieser Sicherung, ist ein Löschen dieses Speicherbereiches höchster Wertigkeit nicht möglich, so daß ein Löschvorgang im Speicher insgesamt unterbunden wird, sobald der Speicherbereich höchster Wertigkeit vollgeschrieben ist.

**Patentansprüche**

1. Verfahren zum Entwerten der monolithisch integrierbaren elektronischen Schaltung einer Debit-Karte, die mindestens aus einer Adreß- und Steuerlogikschaltung und einem nichtflüchtigen Speicher besteht, wobei zumindest ein Teil dieses Speichers elektrisch löschbar ist und alle Speicherplätze des zum Speichern des jeweiligen Entwertungszustandes vorgesehenen Bereiches des nichtflüchtigen Speichers auslesbar und bitweise beschreibbar sind,
   **dadurch gekennzeichnet,**
   daß der besagte, zum Speichern des Entwertungszustandes der Debit-Karte vorgesehene Bereich des Speichers in Teilbereiche jeweils unterschiedlicher Wertigkeit aufgeteilt ist und als mehrstufiger Zähler benutzt wird, daß aufgrund schaltungstechnischer Maßnahmen ein Löschen der Speicherzellen nur für alle Speicherzellen eines Teilbereiches bestimmter Wertigkeit gleichzeitig möglich ist und jeder Teilbereich nur gelöscht werden kann, nachdem das Einschreiben eines Übertragbit in eine zuvor unbeschriebene Speicherzelle des Teilbereiches der nächsthöheren Wertigkeit erfolgt ist und dieses Einschreiben von einer Logikschaltung überwacht worden ist und daß ein Löschen des Teilbereiches der höchsten Wertigkeit nur unter besonderen Bedingungen möglich ist.

2. Verfahren nach Anspruch 1,
   **dadurch gekennzeichnet,**
   daß ein Löschen des Teilbereiches der höchsten Wertigkeit prinzipiell möglich ist, jedoch irreversibel, insbesondere durch Zerstören einer Schmelzsicherung unterbunden werden kann.

3. Monolithisch integrierbare Schaltung zur Realisierung eines Verfahrens nach Anspruch 1 oder 2 unter Verwendung eines elektrisch löschbaren Speichers mit matrixförmig angeordneten Zweitransistor-Speicherzellen mit Auswahltransistor (TAZ) und Speichertransistor (TS), die über Zeilenauswahlleitungen (AZ1, AZ2, ...) und Spaltenauswahlleitungen (AS1, ...) einzeln auswählbar sind, wobei die Speicherzellen zeilenweise mit ihren Steuergateanschlüssen an einer gemeinsamen Steuerleitung angeschlossen sind, wobei die Drainanschlüsse der Speicherzellen-Auswahltransistoren (TAZ) spaltenweise an Spaltenleitungen angeschlossen sind, wobei diese Spaltenleitungen jeweils über ein Lastelement (L) an das Programmierpotential (UP) angeschlossen sind und über Spalten-Schalttransistoren (TAS), die über die an ihre Gateanschlüsse angeschlossenen Spaltenauswahlleitungen (AS1, ..., ASm) angesteuert werden können, an einen gemeinsamen ersten Schaltungsknoten (K1) geschaltet sind,
   **dadurch gekennzeichnet,**
   daß die Steuerleitungen der einzelnen Speicherzellen-Zeilen über je einen Zeilen-Schalttransistor (TS1, TS2, ..., TSn) an einen gemeinsamen zweiten Schaltungsknoten (K2) schaltbar sind, wobei der Gateanschluß eines jeden dieser Zeilen-Schalttransistoren (TS1, TS2, ..., TSn-1) an die Zeilenauswahlleitung des Bereiches nächsthöherer Wertigkeit angeschlossen ist und der Gateanschluß des Zeilen-Schalttransistors des Bereiches der höchsten Wertigkeit über eine speziell gesicherte Leitung (FL) ansteuerbar ist, wobei der zweite Schaltungsknoten (K2) über einen Löschschalttransistor (TLS) an ein Löschpotential (UL) schaltbar ist und daß der Schaltzustand dieses Löschschalttransistors (TLS) von einer Logikschaltung gesteuert wird.

4. Monolithisch integrierbare Schaltung nach Anspruch 3,
   **dadurch gekennzeichnet,**
   daß die speziell gesicherte Leitung (FL) mit einer Schmelzsicherung ausgestattet ist.

5. Monolithisch integrierbare Schaltung nach Anspruch 3,
   **dadurch gekennzeichnet,**
   daß die speziell gesicherte Leitung (FL) nur unter Verwendung eines Sicherungs-Codes aktiviert werden kann.

**6.** Monolithisch integrierbare Schaltung nach einem der Ansprüche 3, 4 oder 5,
**dadurch gekennzeichnet,**
daß der erste Schaltungsknoten (K1) an einen Eingang eines ersten UND-Gatters (G1) und an den Eingang einer Invertierschaltung (G2) geschaltet ist, daß der andere Eingang des ersten UND-Gatters (G1) von einem üblichen Bewertungssignal (EN) beaufschlagbar ist, daß der Ausgang des ersten UND-Gatters (G1) an den Setz-Eingang (S) eines Flip-Flop FF angeschlossen ist, daß der Rücksetzeingang (R) des Flip-Flop FF bei jedem Adreßwechsel von der Adreßlogikschaltung mit einem Rücksetzsignal beaufschlagt wird, daß der Ausgang dieses Flip-Flop (FF) mit dem Eingang eines zweiten UND-Gatters (G3) verbunden ist und der andere Eingang dieses zweiten UND-Gatters (G3) an den Ausgang der Invertierschaltung (G2) angeschlossen ist und daß das Ausgangssignal des zweiten UND-Gatters (G3) zur Beaufschlagung des Steuereinganges des Löschschalttransistors (TLS) vorgesehen ist.

## Claims

**1.** Method for devaluing the monolithically integrable electronic circuit of a debit card, which consists of at least one address and control logic circuit and one non-volatile memory, it being possible to erase at least a part of this memory electrically and it being possible to read and write bit by bit all the memory locations of the area of the non-volatile memory provided for storing the respective devaluation status, characterised in that the aforesaid area of the memory provided for storing the devaluation status of the debit card is divided into subareas having different values in each case and is used as a multi-stage counter, in that, as a result of technical circuitry measures, erasing the memory cells is only possible simultaneously for all memory cells of a subarea having a given value, and each subarea can only be erased once a carry bit has been written into a previously unwritten memory cell of the subarea having the next higher value, and this writing has been monitored by a logic circuit, and in that erasing the subarea of the highest value is only possible if specific conditions are met.

**2.** Method according to Claim 1, characterised in that erasing the subarea having the highest value is in principle possible, but is irreversible, in particular can be prevented by destroying a fuse.

**3.** Monolithically integrable circuit for realising a method according to Claim 1 or 2, using an electrically erasable memory with two-transistor memory cells, arranged in the form of a matrix, with selection transistor (TAZ) and memory transistor (TS) which can be selected individually via row selection lines (AZ1, AZ2, ...) and column selection lines (AS1, ...), in which the memory cells are connected row by row by their control gate terminals to a common control line, in which the drain terminals of the memory cell selection transistors (TAZ) are connected column by column to column lines, in which these column lines are connected in each case via a load element (L) to the programming potential (UP) and are switched via column switching transistors (TAS), which can be driven via the column selection lines (AS1, ..., ASm) connected to their gate terminals, to a common first circuit node (K1), characterised in that the control lines of the individual memory cell rows can be switched to a common second circuit node (K2) in each case via a row switching transistor (TS1, TS2,.... TSn), in which the gate terminal of each of these row switching transistors (TS1, TS2, ..., TSn-1) is connected to the row selection line of the area having the next higher value and the gate terminal of the row switching transistor of the area having the highest value can be driven via a separately protected line (FL), in which the second circuit node (K2) can be switched via an erase switching transistor (TLS) to an erase potential (UL), and in that the switching state of this erase switching transistor (TLS) is controlled by a logic circuit.

**4.** Monolithically integrable circuit according to Claim 3, characterised in that the separately protected line (FL) is equipped with a fuse.

**5.** Monolithically integrable circuit according to Claim 3, characterised in that the separately protected line (FL) can only be activated using a security code.

**6.** Monolithically integrable circuit according to one of Claims 3, 4 or 5, characterised in that the first circuit node (K1) is switched to one input of a first AND gate (G1) and to the input of an inverter circuit (G2), in that a conventional evaluation signal (EN) can be applied to the other input of the first AND gate (G1), in that the output of the first AND gate (G1) is connected to the set input (S) of a flip-flop FF, in that a reset signal is applied to the reset input (R) of the flip-flop FF by the address logic circuit for each address change, in that the output of this flip-flop FF is connected to the input of a second AND gate (G3) and the other input of this second AND gate (G3) is connected to the output of the inverter circuit (G2), and in that the output signal of the second AND gate (G3) is provided for application to the control input of the erase switching transistor (TLS).

**Revendications**

1. Procédé pour invalider le circuit électronique, intégrable sous forme monolithique, d'une carte de débit, qui est constitué au moins par un circuit logique d'adressage et de commande et par une mémoire non volatile, et selon lequel au moins une partie de cette mémoire est effaçable électriquement et tous les emplacements de la zone, prévue pour la mémorisation de l'état d'invalidation, de la mémoire non volatile, peuvent être lus et enregistrés bit-par-bit,
caractérisé par le fait que ladite zone de la mémoire, qui est prévue pour la mémorisation de l'état d'invalidation de la carte de débit, est subdivisée en zones partielles ayant des valeurs respectivement différentes et est utilisée en tant que compteur à étages multiples, que sur la base de dispositions techniques du point de vue des circuits, un effacement des cellules de mémoire est possible simultanément uniquement pour toutes les cellules de mémoire d'une zone partielle ayant une valeur déterminée et que chaque zone partielle ne peut être effacée que lorsque l'enregistrement d'un bit de report est exécuté dans une cellule de mémoire, non enregistrée antérieurement, de la zone partielle possédant la valeur immédiatement supérieure, et qu'un effacement de la zone partielle possédant la valeur maximale n'est possible que dans des conditions particulières.

2. Procédé suivant la revendication 1, caractérisé par le fait qu'un effacement de la zone partielle possédant la valeur maximale est en principe possible, mais peut être bloqué de façon irréversible notamment par destruction d'un fusible.

3. Circuit pouvant être intégré de façon monolithique pour la mise en oeuvre d'un procédé suivant la revendication 1 ou 2, moyennant l'utilisation d'une mémoire effaçable électriquement comportant des zones de mémoire à deux transistors disposées sous la forme d'une matrice et comportant un transistor de sélection (TAZ) et un transistor de mémorisation (TS), qui peuvent être sélectionnés individuellement par l'intermédiaire de conducteurs (AZ1,AZ2...) de sélection de lignes et de conducteurs (AS1, ...) de sélection de colonnes, et dans lequel les cellules de mémoire sont raccordées ligne par ligne, au moyen des bornes de leurs grilles de commande, à un conducteur de commande commun, les bornes de drain des transistors (TAZ) de sélection de cellules de mémoire sont raccordées colonne par colonne à des conducteurs de colonnes, ces conducteurs de colonnes sont raccordés respectivement par l'intermédiaire d'un élément de charge (L) au potentiel de programmation (UP) et, par l'intermédiaire de transistors de commutation de colonnes (TAS), qui peuvent être commandés par l'intermédiaire des conducteurs de sélection de colonnes (AS1..., ASm), qui sont raccordés à leurs bornes de grille, à un premier noeud commun (K1) du circuit,
caractérisé par le fait que les conducteurs de colonnes des différentes lignes de cellules de mémoire peuvent être raccordés, par l'intermédiaire de transistors respectifs de commutation de lignes (TS1,TS2..., TSn), à un second noeud commun (K2) du circuit, la borne de grille de chacun de ces transistors de commutation de lignes (TS1,TS2,... TSn-1) étant raccordée au conducteur de sélection de lignes de la zone possédant la valeur immédiatement supérieure et la borne de grille du transistor de commutation de grille de la zone possédant la valeur la plus élevée pouvant être commandée par l'intermédiaire d'une ligne spécialement protégée (FL), tandis que le second noeud (K2) du circuit peut être raccordé à un potentiel d'effacement (UL) par l'intermédiaire d'un transistor de commutation d'effacement (TLS), et que l'état de commutation de ce transistor de commutation d'effacement (TLS) est commandé par un circuit logique.

4. Circuit pouvant être intégré de façon monolithique suivant la revendication 3, caractérisé par le fait que le conducteur protégé de façon particulière (FL) est équipé d'un fusible.

5. Circuit pouvant être intégré de façon monolithique suivant la revendication 3, caractérisé par le fait que le conducteur spécialement protégé (FL) peut être activé uniquement moyennant l'utilisation d'un code de protection.

6. Circuit pouvant être intégré de façon monolithique suivant l'une des revendications 3,4 ou 5, caractérisé par le fait

que le premier noeud (K1) du circuit est raccordé à une entrée d'une première porte ET (G1) et à l'entrée d'un circuit inverseur (G2), que l'autre entrée de la première porte ET (G1) peut être chargée par un signal usuel de pondération (EN), que la sortie de la première porte ET (G1) est raccordée à l'entrée de positionnement (S) d'une bascule bistable (FF), que l'entrée de remise à l'état initial (R) de la bascule bistable (FF) est chargée, lors de chaque changement d'adresse, au moyen d'un signal de remise à l'état initial par le circuit logique d'adressage, que la sortie de cette bascule bistable (FF) est raccordée à l'entrée d'une seconde porte ET (G3) et que l'autre entrée de cette seconde porte ET (G3) est raccordée à la sortie du circuit inverseur (G2) et que le signal de sortie de la seconde porte ET (G3) est prévu pour être appliqué à l'entrée de commande du transistor de commutation d'effacement (TS).